# EUROPEAN PATENT APPLICATION

(11) **EP 4 788 080 A1**
(43) Date of publication of application: **05.08.2026**
(21) Application number: 25221629.6
(22) Date of filing: 09.12.2025
(51) Int. Cl.: H10B 43/10, H10B 43/50, H10B 43/27

(54) **MEMORY DEVICE AND METHOD OF MANUFACTURING THE MEMORY DEVICE**

(30) Priority: 04.02.2025 KR 20250013751
(71) Applicant: SK hynix Inc., Bubal-eub Icheon-si Gyeonggi-do 17336 (KR)
(72) Inventor: KIM, Tae Woo, 17336 Icheon-si, Gyeonggi-do (KR)
(74) Representative: Isarpatent

(57) **Abstract**

The present application relates to a memory device and a method of manufacturing the memory device. The memory device according to an embodiment of the present disclosure includes cell plugs extending through a stack, select plugs coupled to the cell plugs and disposed over the stack, select lines surrounding the select plugs and disposed over the stack, and an isolation structure separating the select lines and contacting the select plugs.

## Description

### BACKGROUND

### 1. Technical Field

The present disclosure relates to a memory device and a method of manufacturing the memory device, including but not limited to a memory device including a memory block having a three-dimensional structure and a method of manufacturing the memory block.

### 2. Related Art

A memory device may include a non-volatile memory device that retains stored data when the power supply is interrupted. The non-volatile memory device have a two-dimensional structure or a three-dimensional structure, depending on the structure in which memory cells are arranged. Memory cells of a non-volatile memory device having a two-dimensional structure are arranged in a single layer on a substrate. Memory cells of a non-volatile memory device having a three-dimensional structure are stacked vertically on the substrate. Because the integration density of a nonvolatile memory device having a three-dimensional structure is higher than the integration density of a non-volatile memory device having a two-dimensional structure, electronic devices have recently increased use of nonvolatile memory devices having a three-dimensional structure.

### SUMMARY

According to an embodiment, a memory device may include a plurality of cell plugs extending through a stack, a plurality of select plugs each of which coupled to a different one of the plurality of cell plugs and disposed over the stack, a plurality of select lines disposed over the stack, and including a first select line surrounding a first plurality of select plugs among the plurality of select plugs and a second select line surrounding a second plurality of select plugs among the plurality of select plugs, and an isolation structure separating the first select line from the second select line and contacting a subset of the plurality of select plugs.

According to an embodiment, a method of manufacturing a memory device may include forming a plurality of cell plugs extending through a stack, forming, over the stack, a plurality of select plugs each of which coupled to a different one of the plurality of cell plugs, forming a first insulating layer covering the stack and the plurality of select plugs, forming an isolation structure contacting the plurality of select plugs by removing a section of the first insulating layer, and forming, over the stack, a plurality of select lines separated by the isolation structure and contacting the plurality of select plugs.

### BRIEF DESCRIPTION OF THE DRAWINGS

FIG. 1 is a diagram illustrating a memory device according to an embodiment of the present disclosure;
FIG. 2 is a diagram illustrating a memory device according to an embodiment of the present disclosure;
FIG. 3A to FIG. 3D are diagrams illustrating the structure of a memory device according to an embodiment of the present disclosure;
FIG. 4A to FIG. 4Q are diagrams illustrating a memory device formed utilizing a method of manufacturing a memory device according to an embodiment of the present disclosure;
FIG. 5 is a diagram illustrating a memory card system including a memory device according to an embodiment of the present disclosure; and
FIG. 6 is a diagram illustrating a solid state drive (SSD) system including a memory device according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

Terms such as "vertical," "horizontal," "top," "under," "over," "overlap," "on," "side," "upper," "uppermost," "lower," "higher," "high," "column," "row," "level," and other terms implying relative spatial relationship or orientation are utilized only for the purpose of ease of description or reference to a drawing and are not otherwise limiting.

The cross-hatching throughout the figures illustrates corresponding or similar areas between the figures rather than indicating the materials associated with the areas. The drawings are not necessarily drawn to scale and include differing quantities of various structures between the cross-sectional views and corresponding plan views, and complete versions of some structures are not shown between the cross-sectional views and corresponding plan views.

When one element is identified as "coupled" to another element, the elements may be coupled directly or through at least one intervening element between the elements. When two elements are identified as "directly coupled," one element is directly coupled to the other element without an intervening element between the two elements.

Terms such as "first" and "second" are used to distinguish between various components and do not imply size, order, priority, quantity, or importance of the components. For example, a first component may be referred to as a second component in one example, and the second component may be referred to as a first component in another example.

The present disclosure describes a memory device and a method of manufacturing the memory device that can reduce the volume of the memory device compared to conventional methods.

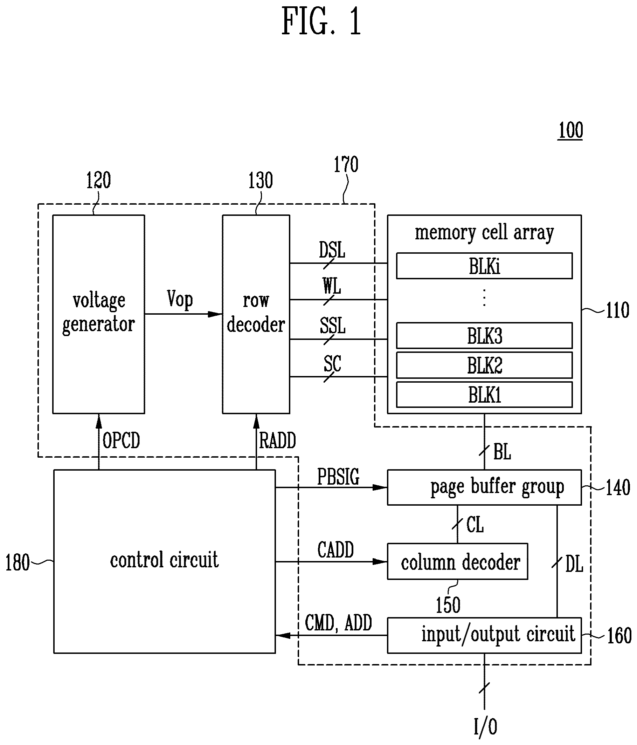

FIG. 1 is a diagram illustrating a memory device 100 according to an embodiment of the present disclosure.

Referring to FIG. 1, the memory device 100 includes a memory cell array 110, a peripheral circuit 170, and a control circuit 180.

The memory cell array 110 includes first to ith memory block BLK1 to BLKi, where i is an integer greater than 1. Each of the first to ith memory blocks BLK1 to BLKi includes memory cells that store data. Drain select lines DSL, word lines WL, source select lines SSL, and source lines SC are coupled to each of the memory blocks BLK1 to BLKi. Bit lines BL are coupled in common to the memory blocks BLK1 to BLKi.

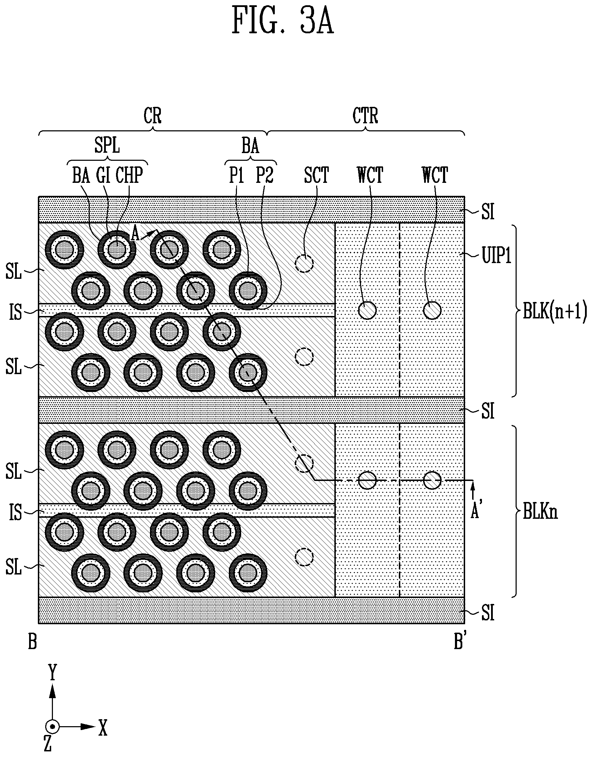

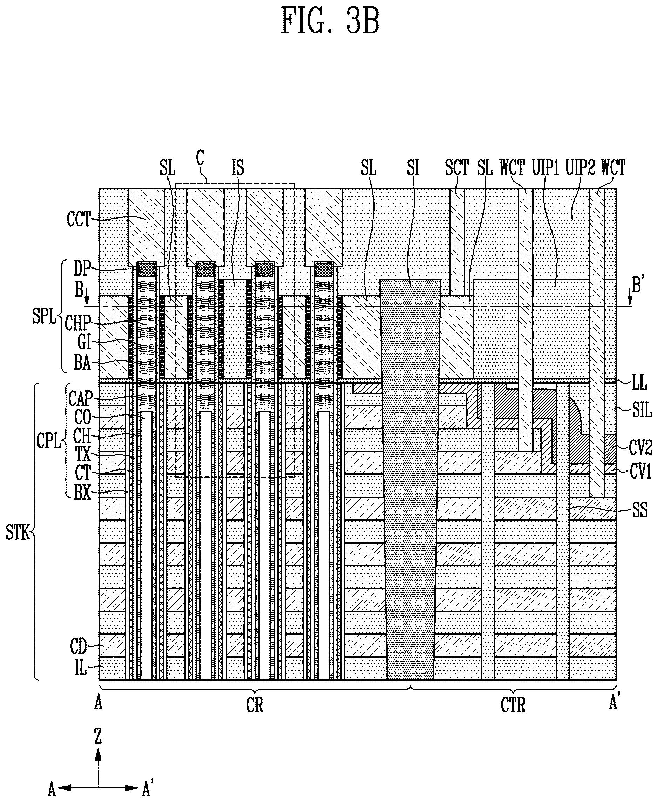

The memory blocks BLK1 to BLKi have a three-dimensional structure. Memory blocks having a three-dimensional structure include memory cells stacked vertically on the substrate. The structure of the memory blocks, such as the memory blocks BLK1 to BLKi, are described with reference to FIG. 3A and FIG. 3B.

Memory cells store one bit or two or more bits of data, depending on how the memory cells are programmed. For example, a single memory cell that stores one bit of data is referred to as a single level cell, and a single memory cell that stores two bits of data is referred to as a multi-level cell. A single memory cell that stores three bits of data is referred to as a triple level cell, and a single memory cell that stores four bits of data is referred to as a quad level cell. More than five bits of data may be stored in a single memory cell.

The peripheral circuit 170 performs a program operation to store data in the memory cell array 110, a read operation to output data stored in the memory cell array 110, and an erase operation to erase data stored in the memory cell array 110. For example, the peripheral circuit 170 includes a voltage generator 120, a row decoder 130, a page buffer group 140, a column decoder 150, and an input/output circuit 160.

The voltage generator 120 generates various operating voltages Vop that are used during a program operation, a read operation, or an erase operation in response to an operation code OPCD. For example, the voltage generator 120 generates program voltages, turn-on voltages, turn-off voltages, negative voltages, precharge voltages, verify voltages, read voltages, pass voltages, and erase voltages in response to the operation code OPCD. The operating voltages Vop generated by the voltage generator 120 are applied to the drain select lines DSL, the word lines WL, the source select lines SSL, and the source lines SC of the selected memory block via the row decoder 130.

Program voltages are applied to a selected word line of the word lines WL during a program operation and are used to increase threshold voltages of the memory cells coupled to the selected word line. Turn-on voltages are applied to the drain select lines DSL and the source select lines SSL and turn on drain select transistors and source select transistors. Turn-off voltages are applied to the drain select lines DSL and the source select lines SSL and turn off the drain select transistors and the source select transistors. For example, the turn-off voltage may be 0 V. Precharge voltages are higher than 0 V and are applied to bit lines during a read operation. Verify voltages are used during a verify operation to determine when the threshold voltage of the selected memory cells reaches a target level. The verify voltages are at various levels depending on the target level and are applied to selected word lines.

Read voltages are applied to a selected word line during a read operation of the selected memory cells. For example, the read voltages are at various levels depending on how the selected memory cells are programmed. Pass voltages are applied to unselected word lines of the word lines WL during a program or read operation and are used to turn on memory cells coupled to unselected word lines. Erase voltages are used to erase memory cells included in selected memory blocks during an erase operation and are applied to the source lines SC.

The row decoder 130 transfers, according to a row address RADD, the operating voltages Vop to the drain select lines DSL, the word lines WL, the source select lines SSL, and the source lines SC coupled to a selected memory block. For example, the row decoder 130 is coupled to the voltage generator 120 through global lines and is coupled to the first to ith memory blocks BLK1 to BLKi using the drain select lines DSL, the word lines WL, the source select lines SSL, and the source lines SC.

The page buffer group 140 includes page buffers (not shown) coupled to the first to ith memory blocks BLK1 to BLKi, respectively. Each of the page buffers is coupled to one of the first to ith memory blocks BLK1 to BLKi via bit lines BL. During a read operation, the page buffers sense a current or a voltage on the bit lines that varies according to the threshold voltages of the selected memory cells in response to page buffer control signals PBSIG and temporarily stores the sensed data.

The column decoder 150 transfers data between the page buffer group 140 and the input/output circuit 160 in response to a column address CADD. For example, the column decoder 150 is coupled to the page buffer group 140 through column lines CL and transfers enable signals via the column lines CL. The page buffers included in the page buffer group 140 receive or output data via data lines DL in response to the enable signals.

The input/output circuit 160 receives or outputs a command CMD, an address ADD, or data through input/output lines I/O. For example, the input/output circuit 160 transfers the command CMD and the address ADD received from an external controller to the control circuit 180 through the input/output lines I/O and transfers data received from the external controller to the page buffer group 140 through the input/output lines I/O. Alternatively, the input/output circuit 160 outputs data received from the page buffer group 140 to the external controller via the input/output lines I/O.

In response to the command CMD and the address ADD, the control circuit 180 outputs at least one of the operation code OPCD, the row address RADD, the page buffer control signals PBSIG, and the column address CADD. For example, when the command CMD input to the control circuit 180 corresponds to a program operation, the control circuit 180 controls the peripheral circuit 170 to perform the program operation on the memory block selected by the address ADD. When the command CMD input to the control circuit 180 corresponds to a read operation, the control circuit 180 controls the peripheral circuit 170 to perform the read operation on the memory block selected by the address ADD and output the read data. When the command CMD input to the control circuit 180 corresponds to an erase operation, the control circuit 180 controls the peripheral circuit 170 to perform the erase operation on the selected memory block.

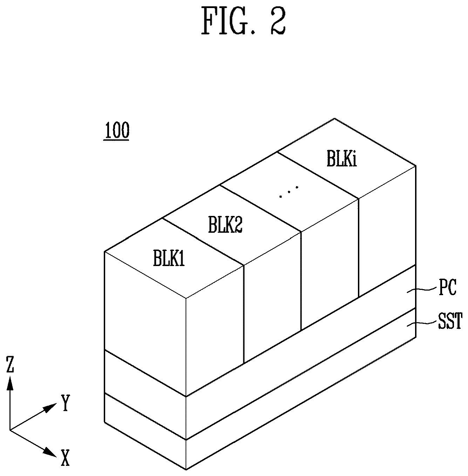

FIG. 2 is a diagram illustrating the memory device 100 according to an embodiment of the present disclosure.

Referring to FIG. 2, the memory device 100 includes a peripheral circuit structure PC, arranged on a substrate SST, and the first to ith memory blocks BLK1 to BLKi. The first to ith memory blocks BLK1 to BLKi are disposed over the peripheral circuit structure PC.

The substrate SST may be a single crystal semiconductor layer. For example, the substrate SST may be a bulk silicon substrate, a silicon-on-insulator substrate, a germanium substrate, a germanium-on-insulator substrate, a silicon-germanium substrate, or an epitaxial thin film formed by selective epitaxial growth.

The peripheral circuit structure PC includes the row decoder 130, the column decoder 150, the page buffer group 140, and the control circuit 180 that include circuitry that controls operations on the first to ith memory blocks BLK1 to BLKi. For example, the peripheral circuit structure PC may include NMOS transistors, PMOS transistors, resistors, and capacitors electrically coupled to the first to ith memory blocks BLK1 to BLKi. The peripheral circuit structure PC may be arranged between the substrate SST and the first to ith memory blocks BLK1 to BLKi.

Each of the first to ith memory blocks BLK1 to BLKi includes a source structure, bit lines, cell strings electrically coupled to the source structure and the bit lines, word lines electrically coupled to the cell strings, and select lines electrically coupled to the cell strings. Each of the cell strings includes memory cells and select transistors coupled in series by cell plugs. Each of the select lines is a gate electrode of a corresponding select transistor, and each of the word lines is a gate electrode of a corresponding memory cell. Consecutive memory blocks BLK1 to BLKi are separated by a slit. The select lines included in each of the memory blocks BLK1 to BLKi are separated in a horizontal direction by an isolation structure. The slit and the isolation structure are described with reference to FIG. 3A to FIG. 3C.

In an embodiment, the substrate SST, the peripheral circuit structure PC, and the first to ith memory blocks BLK1 to BLKi are stacked in a different order than the order shown in FIG. 2. For example, the peripheral circuit structure PC may be arranged on top of the memory blocks BLK1 to BLKi.

In an alternative embodiment, the peripheral circuit structure PC is arranged on regions of the substrate SST that do not overlap the memory blocks BLK1 to BLKi. For example, the peripheral circuit structure PC and the memory blocks BLK1 to BLKi may be located in different regions of the substrate SST that do not vertically overlap with each other.

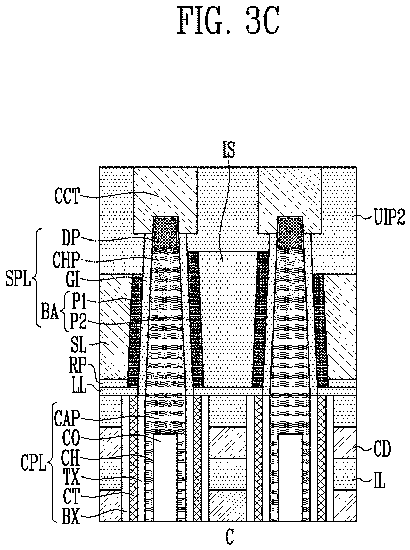

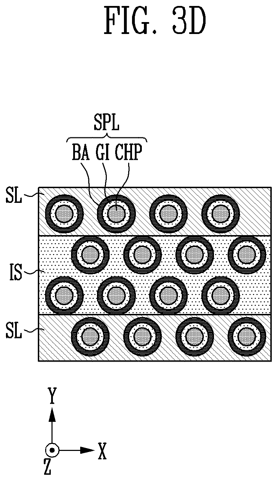

FIG. 3A to FIG. 3D are diagrams illustrating the structure of a memory device according to an embodiment of the present disclosure. FIG. 3A is a plan view illustrating the layout of a memory device according to an embodiment of the present disclosure. FIG. 3B is a cross-sectional diagram along line A-A' of FIG. 3A. FIG. 3C is an enlarged view of area C in FIG. 3B. FIG. 3D is a plan view illustrating an isolation structure according to an embodiment of the present disclosure.

FIG. 3A illustrates two neighboring memory blocks among the first to ith memory blocks BLK1 to BLKi of FIG. 2. FIG. 3A illustrates part of an nth memory block BLKn and part of an (n+1) memory block BLK(n+1), where n is an integer greater than 1. The nth memory block BLKn and the (n+1) memory block BLK(n+1) are described with reference to FIG. 3A as an example among the memory blocks BLK1 to BLKi.

The nth memory block BLKn is consecutive with the (n+1) memory block BLK(n+1) in a Y direction. The (n+1) memory block BLK(n+1) is located next to the nth memory block BLKn in the Y direction. The nth memory block BLKn and the (n+1) memory block BLK(n+1) extend in an X direction. The nth memory block BLKn is separated from the (n+1) memory block BLK(n+1) are separated by a slit structure SI. The slit structure SI is interposed between the nth memory block BLKn and the (n+1) memory block BLK(n+1). The slit structure SI isolate the nth memory block BLKn from the (n+1) memory block BLK(n+1). The slit structure SI are located on either side of the nth memory block BLKn, for example, in the Y direction. The slit structure SI are located on either side of the (n+1) memory block BLK(n+1), for example, in the Y direction. The slit structure SI extend in the X direction. The slit structure SI are filled with a single layer or multiple layers. For example, each of the slit structure SI includes an insulating layer. In an example, each of the slit structure SI includes a conductive layer and an insulating layer surrounding the conductive layer.

The nth memory block BLKn and the (n+1) memory blocks BLK(n+1) includes a cell region CR and a contact region CTR. A contact region CTR extends from each of the cell regions CR in the X direction. The contact regions CTR may extend from the cell regions CR in the X direction. In an alternative embodiment (not shown), the contact region CTR extends from an opposite end of the cell region CR in the X direction or extends from both sides of the cell region CR in the X direction. The cell region CR and the contact region CTR may have various arrangements.

Cell plugs and select plugs SPL are arranged in the cell region CR. In FIG. 3A, the select plugs SPL are shown. Each of the select plugs SPL extends from one of the cell plugs in a Z direction. The structure of the cell plugs is described with reference to FIG. 3B.

The select plugs SPL are arranged in the X direction and the Y direction. For example, the centers of the select plugs SPL in an odd-numbered row are offset from the centers of select plugs in an even-numbered row. The select plugs SPL are spaced apart in the X direction and the Y direction. Each of the select plugs SPL extends in the Z direction. Each of the select plugs SPL is electrically coupled to a bit line, such as the bit line BL in FIG. 1, and a source line, such as the source line SC in FIG. 1, through a wiring structure.

Each of the select plugs SPL include a channel pillar CHP, a gate insulating layer GI, and a barrier layer BA. The channel pillar CHP may have a cylindrical shape. The gate insulating layer GI surrounds the channel pillar CHP. The gate insulating layer GI may have a cylindrical shape and contacts a side surface of the channel pillar CHP. The channel pillar CHP may fill the inside of the gate insulating layer GI. The barrier layer BA surrounds the gate insulating layer GI. The barrier layer BA contacts a side surface of the gate insulating layer GI. The barrier layer BA may have a cylindrical shape.

The channel pillar CHP may include an undoped silicon layer or a doped silicon layer. For example, a section of the channel pillar CHP may be an undoped silicon layer and another section may be a doped silicon layer. The gate insulating layer GI may be an oxide layer such as a silicon oxide layer. The barrier layer BA may be a nitride layer such as titanium nitride.

Each of the select lines SL ay extends in the X direction. The select lines SL extend from the cell region CR through the contact region CTR. The select lines SL are arranged in the Y direction. The select lines SL are arranged consecutively in the Y direction. For example, the select lines SL of the nth memory block BLKn and the select lines SL of the (n+1) memory block BLK(n+1) are arranged consecutively in the Y direction with the slit structure SI interposed between the nth memory block BLKn and the (n+1) memory block BLK(n+1). Each of the nth memory block BLKn and the (n+1) memory block BLK(n+1) includes two or more select lines SL. For example, two consecutive select lines SL in the Y direction are located in the nth memory block BLKn. The select lines SL may include a conductive material such as tungsten (W).

The select lines SL are separated by an isolation structure IS. For example, two or more consecutive select lines SL included within one memory block, such as the nth memory block BLKn, are isolated by the isolation structure IS. The isolation structure IS extends in the X direction. One or more isolation structures IS are arranged between consecutive slit structure SI in the Y direction. The quantity of isolation structures IS arranged between consecutive slit structure SI in the Y direction may determine the quantity of select lines SL included in one memory block. For example, the nth memory block BLKn includes one isolation structure IS and two select lines SL. The isolation structure IS may include an insulating material, such as an oxide.

The select lines SL surround the select plugs SPL. The select lines SL are located between the select plugs SPL in the cell region CR. For example, the select lines SL fill the space between consecutive select plugs SPL. The select lines SL contact the barrier layer BA of the select plugs SPL.

The isolation structure IS contacts the select plugs SPL. The isolation structure IS is located between groups such as rows or columns of the select plugs SPL in the cell region CR. For example, the isolation structure IS are arranged between the select plugs SPL surrounded by different select lines SL among the select plugs SPL. In an embodiment, the isolation structure IS fills the space between groups of the select plugs SPL. The isolation structure IS contacts the barrier layer BA of some of the select plugs SPL.

In an embodiment, a width of the isolation structure IS, such as a distance in the Y direction, corresponds to a distance between the select plugs SPL. For example, in FIG. 3A, the isolation structure IS included in the nth memory block BLKn have a side that contacts a second row of the select plugs SPL and a third row of the select plugs SPL included in the nth memory block BLKn. In an embodiment, the width of the isolation structure IS is greater than a width of the isolation structure IS as shown in FIG. 3A. An embodiment in which the width of the isolation structure IS is different is described with reference to FIG. 3D.

The barrier layer BA within each of the select plugs SPL includes a first section P1 contacting the select line SL and a second section P2 contacting the isolation structure IS. For example, in FIG. 3A, the select plug SPL contacting the isolation structure IS includes the first section P1 and the second section P2. In FIG. 3A, the select plug SPL proximate to the slit structure SI include the first section P1 and do not include the second section P2.

Select line contacts SCT and word line contacts WCT are arranged in the contact region CTR. A plurality of contacts are arranged in the contact region CTR. FIG. 3A shows a subset of the select line contacts SCT and a subset of the word line contacts WCT.

Each of the select line contacts SCT is coupled to a different one of the select lines SL. The select line contacts SCT is coupled to corresponding select lines SL. The word line contacts WCT extend through a first upper insulation pattern UIP1. The word line contacts WCT are spaced apart in the X direction. For example, in the nth memory block BLKn, the word line contacts WCT are arranged in the X direction. The word line contacts WCT are arranged in various different layouts in the contact region CTR. For example, the word line contacts WCT are not arranged in the X direction, but are arranged in an offset or zigzag pattern in the Y direction. The select line contacts SCT and the word line contacts WCT extend in the Z direction. The select line contacts SCT and the word line contacts WCT may include a conductive material such as tungsten. The structures of the select line contacts SCT, the word line contacts WCT, and the first upper insulation pattern UIP1 are described with reference to FIG. 3B.

FIG. 3B is a cross-sectional diagram corresponding to a line A-A' of FIG. 3A. FIG. 3A is a plan view corresponding to a line B-B' of FIG. 3B.

A stack STK include conductive layers CD and interlayer insulating layers IL. The conductive layers CD are alternately stacked with the interlayer insulating layers IL in a Z direction. Consecutive conductive layers CD are insulated by the interlayer insulating layers IL. The conductive layers CD may include at least one of tungsten (W, cobalt (Co), nickel (Ni), molybdenum (Mo), silicon (Si), or polysilicon (poly-Si). The conductive layers CD correspond to the word line WL or the source select line SSL of FIG. 1. The interlayer insulating layers IL may include an oxide layer such as a silicon oxide layer.

In the contact region CTR, the stack STK has a stepped structure. The stack STK includes a plurality of steps formed in the contact region CTR. Each of the plurality of steps includes a conductive layer CD and an interlayer insulating layer IL. For example, each of the plurality of steps includes a single interlayer insulating layer IL on a single conductive layer CD. In an alternative example, each of the plurality of steps includes a single interlayer insulating layer IL under a single conductive layer CD. Although FIG. 3B illustrates the steps arranged in the X direction, the shape of the stepped structure is not limited to the example of FIG. 3B. For example, the stack STK include steps arranged in the Y direction in the contact region CTR. In an example, the stack STK include steps arranged in the X direction and in the Y direction in the contact region CTR.

The stack STK includes a first cover layer CV1, a second cover layer CV2, and a stepped insulating layer SIL formed sequentially on the stepped structure in the contact region CTR. The first cover layer CV1 directly contacts the stepped structure of the stack STK in an embodiment. The first cover layer CV1 is conformally formed along the surfaces of the steps. The first cover layer CV1 may include an insulating material. The second cover layer CV2 is formed on the first cover layer CV1. The second cover layer CV2 extends on the surface of the first cover layer CV1. The second cover layer CV2 may be thicker than the first cover layer CV1. The second cover layer CV2 may include SiCN. The stepped insulating layer SIL is located on the second cover layer CV2. An upper surface of the stepped insulating layer SIL is located at the same level as an upper surface of the uppermost interlayer insulating layer IL. The stepped insulating layer SIL may include an oxide material.

Support structures SS are arranged in the contact region CTR. The support structures SS extend through the stack STK in the contact region CTR. The support structures SS extend through a subset of the interlayer insulating layers IL, a subset of the conductive layers CD, the first cover layer CV1, the second cover layer CV2, and the stepped insulating layer SIL. The height of the support structures SS corresponds to the height of the stack STK. The upper surface of the support structures SS is located at the same level as the upper surface of the stack STK. In an embodiment, the support structures SS extend through each step. In an embodiment, more or fewer support structures SS than those in FIG. 3B are arranged. The support structures SS may include an insulating material.

The select lines SL are located on the stack STK. The select lines SL may partially cover the stack STK. The select lines SL may include a conductive material such as tungsten (W). The select lines SL may correspond to the drain select lines DSL of FIG. 1. According to the present disclosure, the select lines SL corresponding to the drain select lines DSL are formed separately on the stack STK, such that the conductive layers CD in the stack STK operate as the word lines WL or the source select lines SSL.

The thickness of the select lines SL, such as the thickness in the Z direction, is larger than the thickness of the conductive layers CD. Because the select lines SL are thicker than the conductive layers CD, a single layer of the select line SL transfers sufficient voltage to operate a drain select transistor when the drain select line DSL does not include multiple conductive layers.

The isolation structure IS is located between the select lines SL. The isolation structure IS directly contacts the select plugs SPL. The isolation structure IS fills the space between consecutive select plugs SPL and is interposed between the consecutive select plugs SPL. The isolation structure IS may be formed when the spacing between the select plugs SPL is relatively narrow. According to the present disclosure, the length of each of the memory blocks in the Y direction may be reduced.

The height of the isolation structure IS, such as the height in the Z direction, may be greater the height of the select lines SL. When the height of the isolation structure IS is larger than the height of the select lines SL, leakage between different select lines SL may be prevented or reduced. The height of the isolation structure IS may be shorter than the height of the select plugs SPL.

Cell plugs CPL extend through the cell region CR of the stack STK. Each of the cell plugs CPL includes a blocking layer BX, a charge trap layer CT, a tunneling layer TX, a channel layer CH, a capping layer CAP, and a core pillar CO in this example. Each of the blocking layer BX, the charge trap layer CT, and the tunneling layer TX may have a cylindrical shape. The blocking layer BX contacts the stack STK. The charge trap layer CT extends along an inner surface of the blocking layer BX. The tunneling layer TX extends along an inner surface of the charge trap layer CT. The channel layer CH extends along an inner surface of the tunneling layer TX. The core pillar CO fills the inside of the channel layer CH. The core pillar CO may have a cylindrical shape surrounded by the channel layer CH. The capping layer CAP is coupled to the channel layer CH and is disposed on the core pillar CO.

The blocking layer BX and the tunneling layer TX may include an oxide layer, such as a silicon oxide layer, an oxynitride layer such as a silicon oxynitride layer, or a combination thereof. The charge trap layer CT may include a nitride layer or a variable resistance material. The channel layer CH and the capping layer CAP may include an undoped or doped silicon layer. The core pillar CO may include an insulating layer such as an oxide layer or a conductive layer.

Memory cells and select transistors are formed at intersections between the cell plugs CPL and the conductive layers CD. The cell plugs CPL are a channel region of a cell string. For example, memory cells and source select transistors are formed at intersections between the cell plugs CPL and the conductive layers CD.

The select plugs SPL are formed on the stack STK. Each select plug SPL is coupled to a corresponding cell plug CPL. The select plugs SPL extend away from the stack STK in the Z direction. For example, the select plugs SPL extend away from the conductive layers CD and the interlayer insulating layers IL in the Z direction.

Each of the select plugs SPL includes a channel pillar CHP that contacts the capping layer CAP of a corresponding cell plug CPL. The channel pillars CHP may have a cylindrical shape extending in the Z direction. The channel pillars CHP may include doped regions DP. For example, the doped regions DP may be formed at the top of the channel pillars CHP. The doped regions DP may be regions of the channel pillars CHP into which impurities are injected.

Each of the select plugs SPL includes the gate insulating layer GI contacting a side surface of the channel pillar CHP. The gate insulating layer GI is located between the channel pillar CHP and the select line SL. The gate insulating layer GI surrounds at least a section of the channel pillar CHP. In an embodiment, the gate insulating layer GI surrounds the channel pillar CHP except for the doped region DP. The gate insulating layer GI may surround at least a section of the side of the doped region DP. An upper surface of the gate insulating layer GI is located between an upper surface of the doped region DP and a lower surface of the doped region DP.

Each of the select plugs SPL includes the barrier layer BA contacting a side surface of the gate insulating layer GI. The barrier layer BA is located between the gate insulating layer GI and the select line SL. The barrier layer BA surrounds at least a section of the channel pillar CHP and at least a section of the gate insulating layer GI. The height of the barrier layer BA is shorter than the height of each of the channel pillar CHP and the gate insulating layer GI.

Referring to FIG. 3A and FIG. 3B, the first section P1 of the barrier layer BA is located between the channel pillar CHP and the select line SL. The first section P1 does not extend beyond the select lines SL. For example, the upper surface of the first section P1 is at the same level as the upper surface of the select lines SL. The second section P2 of the barrier layer BA is located between the channel pillar CHP and the isolation structure IS. The second section P2 does not protrude beyond the isolation structure IS. For example, the upper surface of the second section P2 is at the same level as the upper surface of the isolation structure IS.

The height of the first section P1 of the barrier layer BA, such as the height in the Z-direction, is shorter than the height of the second section P2. Because the height of the isolation structure IS is greater than the height of the select lines SL, the height of the second section P2 is taller than the height of the first section P1. The upper surface of the second section P2 is located higher than the upper surface of the first section P1. The lower surface of the first section P1 and the lower surface of the second section P2 are at the same level.

A liner layer LL extends along the upper surface of the stack STK. The liner layer LL extends from the gate insulating layers GI of the select plugs SPL. The liner layer LL is as thick as or thicker than the gate insulating layer GI. The liner layer LL contacts lower surfaces of the select lines SL, lower surfaces of the barrier layers BA and a lower surface of the isolation structure IS. The select plugs SPL extend from the stack STK further than the isolation structure IS and the select lines SL extend from the stack STK. Because the isolation structure IS and the select lines SL are located on the liner layer LL, and the select plugs SPL are directly contact the cell plugs CPL, the lower surfaces of the select plugs SPL are located at a lower level than the lower surfaces of the isolation structure IS and the select lines SL. FIG. 3B illustrates the boundary between the liner layer LL and the gate insulating layer GI. The liner layer LL and the gate insulating layer GI may be contiguously formed.

Cell contacts CCT are coupled to corresponding select plugs SPL. The cell contacts CCT may directly contact the channel pillars CHP. For example, the cell contacts CCT contact the doped regions DP. The width of the cell contacts CCT, such as the width in the X direction, is wider than the width of the channel pillars CHP. The cell contacts CCT contact the upper surface of the gate insulating layer GI. The doped regions DP extend into the cell contacts CCT. The cell contacts CCT are electrically coupled to the cell plugs CPL and the select plugs SPL to a bit line, such as the bit line BL in FIG. 1. The cell contacts CCT may include a conductive material such as tungsten.

The slit structure SI extends through the stack STK and the select line SL. The slit structure SI extends through the interlayer insulating layers IL and the conductive layers CD of the stack STK. The slit structure SI isolates the select lines SL in consecutive memory blocks from each other. In FIG. 3B, the cell region CR and the contact region CTR are separated by the slit structure SI. In FIG. 3A, the slit structure SI is located between consecutive memory blocks, such as the nth memory block BLKn and the (n+1) memory block BLK(n+1). Because FIG. 3B illustrates the cell region CR of the (n+1) memory block BLK(n+1) and the contact region CTR of the nth memory block BLKn due to location of the line A-A', the slit structure SI is located between the cell region CR and the contact region CTR along line A-A', although the slit structure SI does not separate the cell region CR and the contact region CTR.

The select line contacts SCT and the word line contacts WCT are arranged in the contact region CTR. The select line contacts SCT contact the upper surface of the select line SL. The select line contacts SCT extend in the Z direction from the select line SL. The select line contact SCT is electrically coupled to the select line SL. Referring to FIG. 3A and FIG. 3B, each select line contact SCT is coupled to a corresponding select lines SL. Each select line contact SCT is coupled on a one-to-one basis to a corresponding select line SL.

Each of the word line contacts WCT contacts a corresponding conductive layer CD. The word line contacts WCT extend in the Z direction from the conductive layers CD. Each of the word line contacts WCT is electrically coupled to a corresponding conductive layer CD. In the contact region CTR, the conductive layers CD are coupled to the word line contacts WCT included in the steps of the stack STK. For example, each of the word line contacts WCT extends through the liner layer LL, the stepped insulating layer SIL, the second cover layer CV2, the first cover layer CV1, and the interlayer insulating layer IL to contact a different one of the conductive layers CD. A subset of the word line contacts WCT is shown in FIG. 3B, and a memory block, such as the nth memory block BLKn, includes a quantity of word line contacts WCT corresponding to a quantity of conductive layers CD. The memory block, such as the nth memory block BLKn, includes a source select line contact coupled to each of the conductive layers CD forming the source select lines SSL.

The word line contacts WCT extend through the first upper insulation pattern UIP1 and a second upper insulation pattern UIP2. The first upper insulation pattern UIP1 is located within the contact region CTR of the stack STK. The first upper insulation pattern UIP1 is disposed over or overlaps the stepped structure of the stack STK. The first upper insulation pattern UIP1 contacts the liner layer LL. The height of the first upper insulation pattern UIP1, such as the height in the Z direction, may be the same as the height of the isolation structure IS. The first upper insulation pattern UIP1 may contact a side surface of the select line SL. The first upper insulation pattern UIP1 may include the same material as the isolation structure IS. For example, the first upper insulation pattern UIP1 may include an oxidized material.

The second upper insulation pattern UIP2 covers the stack STK, the select lines SL, the slit structure SI, and the first upper insulation pattern UIP1. The second upper insulation pattern UIP2 contacts the gate insulating layers GI of the select plugs SPL. The second upper insulation pattern UIP2 surrounds the cell contacts CCT. The cell contacts CCT are insulated from each other by the second upper insulation pattern UIP2. The second upper insulation pattern UIP2 contacts the upper surfaces of the select lines SL. The second upper insulation pattern UIP2 contacts the upper surface of the slit structure SI and contacts a section of the side surface of the slit structure SI. The select line contacts SCT and the word line contacts WCT extend through the second upper insulation pattern UIP2. The second upper insulation pattern UIP2 may include an insulating material such as an oxide.

FIG. 3C is an enlarged view of region C of FIG. 3B as described with reference to FIG. 3A and FIG. 3B.

Referring to FIG. 3C, a width of an upper end of the select plugs SPL has the same width or a narrower width as to a width of a lower end of the select plugs SPL. For example, as shown in FIG. 3B, the upper end has substantially the same width as the lower end of the select plugs SPL. For example, the width of the select plugs SPL may vary with height, such as shown in FIG. 3C.

The channel pillars CHP have a conical shape with the narrowest width at the top. For example, each channel pillar CHP may have a width of 85 nm at a lower end and a width of 64 nm at an upper end. The smaller the difference between the widths of the upper end and lower end of the channel pillars CHP, the better the operational performance of the drain select transistor. The gate insulating layers GI are formed along the side surfaces of the channel pillars CHP with a constant thickness, such as 10 nm. The barrier layers BA may be formed with a constant thickness, such as 10 nm, along the side surfaces of the gate insulating layers GI. The first section P1 of the barrier layers BA is shorter than the second section P2 in the Z direction.

The gate insulating layers GI extend from the liner layer LL. The liner layer LL may include the same material as the gate insulating layers GI.

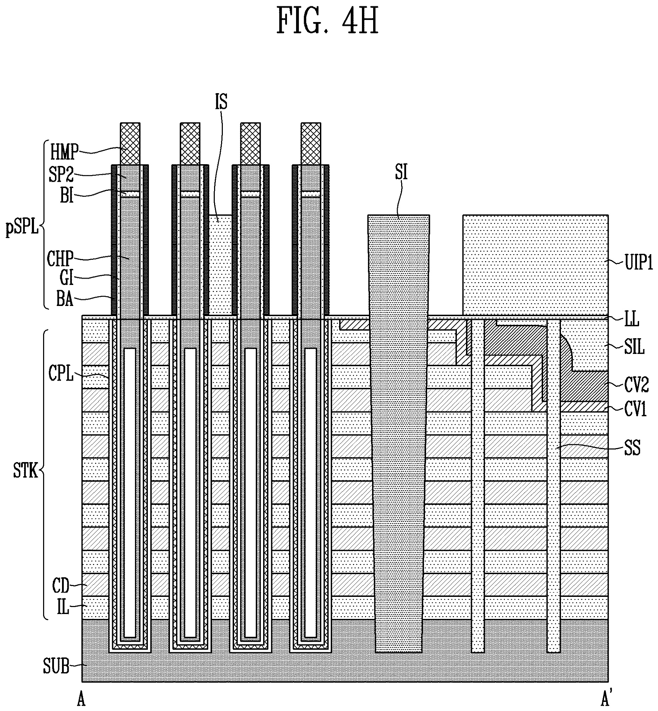

Referring to FIG. 3B, a residual section RP is formed on the liner layer LL. The residual section RP is located between the liner layer LL and the select line SL. The residual section RP may include the same material as the isolation structure IS. The residual section RP is described with reference to FIG. 4H.

Referring to FIG. 3D, the width of the isolation structure IS in the Y direction is greater than the width shown in FIG. 3A. The width of the isolation structure IS as shown in FIG. 3D may be the maximum width of the isolation structure. For example, the isolation structure IS may have various widths such that the barrier layers BA included in the select plugs SPL in the second and third rows that are located within the isolation structure IS in FIG. 3D contact the select lines SL.

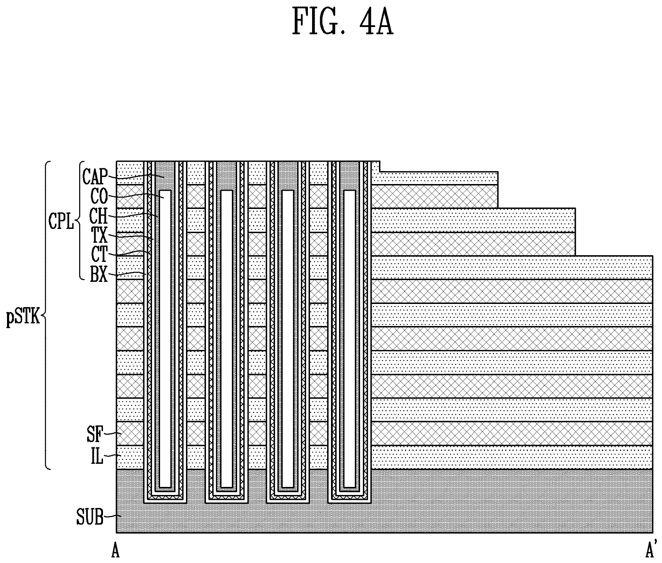

FIG. 4A to FIG. 4Q are diagrams illustrating a memory device formed utilizing a method of manufacturing a memory device according to an embodiment of the present disclosure. FIG. 4A to FIG. 4Q are cross-sections along line A-A' of FIG. 3A.

Referring to FIG. 4A, a preliminary stack pSTK is formed on a substrate SUB. The preliminary stack pSTK includes sacrificial layers SF and interlayer insulating layers IL. The sacrificial layers SF are alternately stacked with the interlayer insulating layers IL in the Z direction.

The interlayer insulating layers IL include an insulating material. For example, the interlayer insulating layers IL may include an oxide layer. The interlayer insulating layers IL may include a silicon oxide layer or a similar oxide material. The sacrificial layers SF include a material that may be selectively removed in a subsequent process. Thus, the sacrificial layers SF may include a material having a different etch selectivity from the interlayer insulating layers IL. The sacrificial layers SF may include a nitride material. For example, the sacrificial layers SF may include a silicon nitride layer.

The cell plugs CPL are formed through the preliminary stack pSTK. The cell plugs CPL extend through the interlayer insulating layers IL and the sacrificial layers SF of the preliminary stack pSTK and into the substrate SUB. The cell plugs CPL include the blocking layer BX, the charge trap layer CT, the tunneling layer TX, the channel layer CH, the core pillar CO, and the capping layer CAP. The capping layer CAP may include an undoped silicon layer.

Sections of the interlayer insulating layers IL and the sacrificial layers SF are etched to form a stepped structure. For example, in the contact region CTR of FIG. 3A and FIG. 3B, a stepped structure is formed such that the preliminary stack pSTK includes steps.

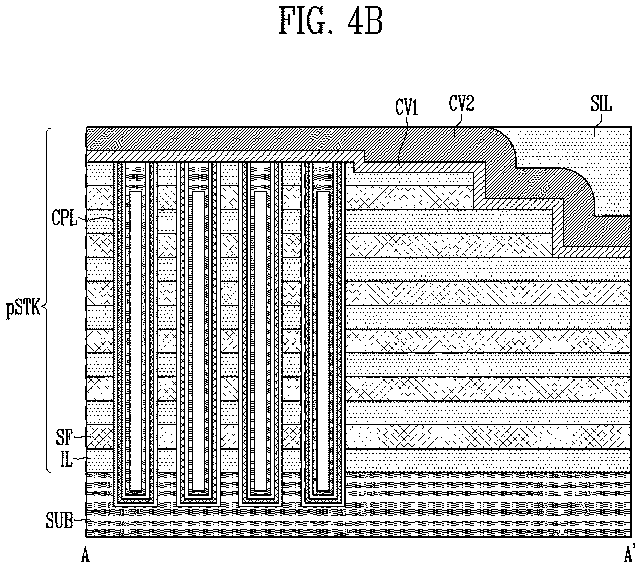

Referring to FIG. 4B, the first cover layer CV1, the second cover layer CV2, and the stepped insulating layer SIL are formed sequentially on the stepped structure of the interlayer insulating layers IL and the sacrificial layers SF. The first cover layer CV1 is conformally formed along the surfaces of the interlayer insulating layers IL and the sacrificial layers SF. The second cover layer CV2 is conformally formed along the surface of the first cover layer CV1. After the stepped insulating layer SIL is formed on the second cover layer CV2, a planarization process is performed.

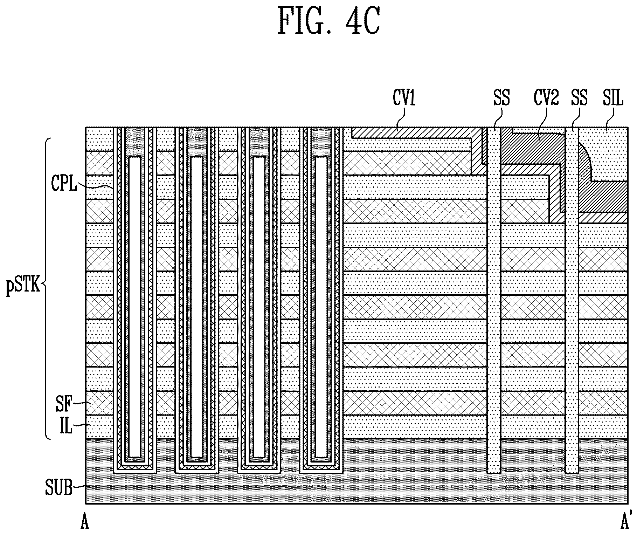

Referring to FIG. 4C, a section of the first cover layer CV1, a section of the second cover layer CV2, and a section of the stepped insulating layer SIL are removed to expose the upper surfaces of the cell plugs CPL. For example, the top section of the preliminary stack pSTK is removed until the upper surface of each of the cell plugs CPL is exposed using the planarization process.

The support structures SS are formed in the preliminary stack pSTK. The support structures SS extend through the preliminary stack pSTK and into the substrate SUB.

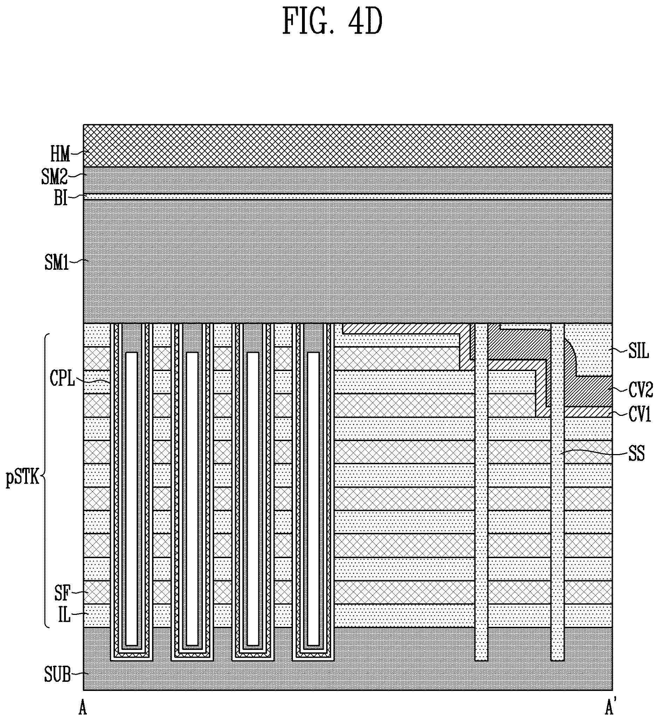

Referring to FIG. 4D, a first semiconductor layer SM1, a barrier insulating layer BI, a second semiconductor layer SM2, and a hard mask HM are formed sequentially on the preliminary stack pSTK. The first semiconductor layer SM1 contacts the upper surface of the preliminary stack pSTK. The first semiconductor layer SM1 is thicker than the second semiconductor layer SM2 in the Z direction. For example, the first semiconductor layer SM1 may have a height of 250 nm and the second semiconductor layer SM2 may have a height of 50 nm. The first semiconductor layer SM1 includes the same materials as the second semiconductor layer SM2. For example, the first semiconductor layer SM1 and the second semiconductor layer SM2 may include polysilicon. The barrier insulating layer BI extends between the first semiconductor layer SM1 and the second semiconductor layer SM2. The barrier insulating layer BI is arranged between the first semiconductor layer SM1 and the second semiconductor layer SM2 to protect the first semiconductor layer SM1. The barrier insulating layer BI may have a thickness as small as 5 nm. The barrier insulating layer BI may include an oxide material. The hard mask HM covers the second semiconductor layer SM2. The hard mask HM may include a nitride material.

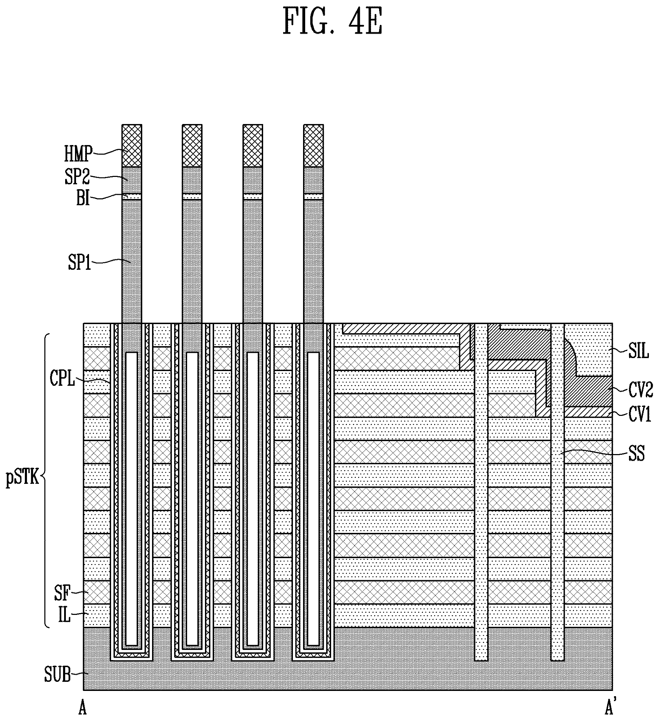

Referring to FIG. 4E, the first semiconductor layer SM1, the second semiconductor layer SM2, and the hard mask HM are patterned to form first semiconductor patterns SP1, second semiconductor patterns SP2, and hard mask patterns HMP. A section of each of the first semiconductor layer SM1, the barrier insulating layer BI, the second semiconductor layer SM2, and the hard mask HM may be etched using a self-aligning etch process. The first semiconductor patterns SP1, the barrier insulating layer BI, the second semiconductor patterns SP2, and the hard mask patterns HMP are disposed over or overlap on the cell plugs CPL. The first semiconductor patterns SP1 contact corresponding cell plugs CPL.

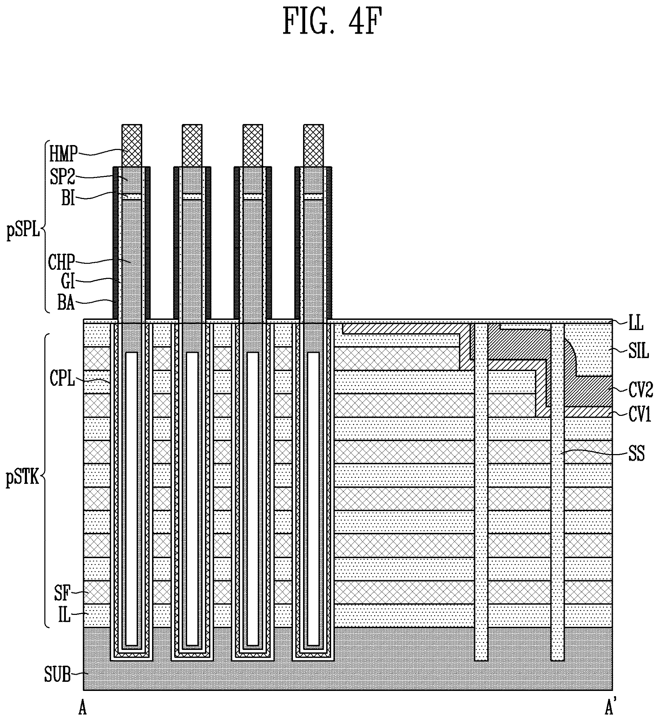

Referring to FIG. 4F, an oxidation process is performed to oxidize the surfaces of the first semiconductor patterns SP1 and the second semiconductor patterns SP2. Residual areas remaining after the surface of the first semiconductor patterns SP1 is oxidized are referred to as the channel pillars CHP. An oxide layer formed by oxidizing the surfaces of the first semiconductor patterns SP1 is referred to as the gate insulating layer GI. The channel pillars CHP are coupled correspondingly to the cell plugs CPL. The surfaces of the second semiconductor patterns SP2 are oxidized to form the gate insulating layer GI. The gate insulating layer GI surround the side surfaces of the channel pillars CHP and the second semiconductor patterns SP2. The upper surface of the gate insulating layer GI is located at a same level as the upper surface of the second semiconductor pattern SP2. The channel pillar CHP, the barrier insulating layer BI, the second semiconductor pattern SP2, the gate insulating layer GI, the barrier layer BA, and hard mask pattern HMP form a preliminary select plug pSPL. The preliminary select plugs pSPL are coupled to corresponding cell plugs CPL. When the gate insulating layer GI is formed, the liner layer LL may be formed on the upper surface of the preliminary stack pSTK.

The barrier layers BA are deposited on the side surfaces of the gate insulating layers GI. The barrier layers BA surround the side surfaces of the gate insulating layers GI. The barrier layers BA contact the side surfaces of the gate insulating layers GI. The barrier layers BA are located on top of the liner layer LL. The upper surface of the barrier layers BA is located at the same level as the upper surface of the second semiconductor pattern SP2 and the upper surface of the gate insulating layers GI. The barrier layers BA may include titanium nitride.

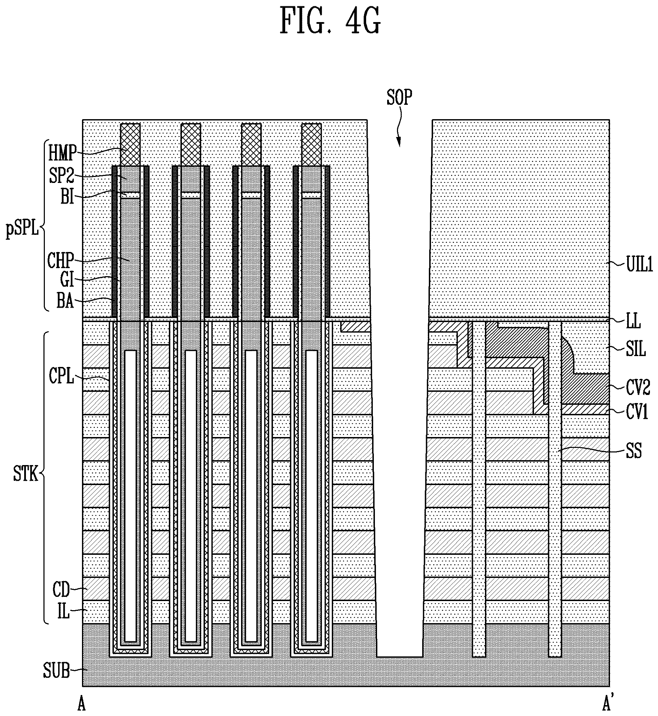

Referring to FIG. 4G, a first upper insulating layer UIL1 covering the preliminary stack pSTK and the preliminary select plugs pSPL is formed. The first upper insulating layer UIL1 is formed to surround the channel pillars CHP, the second semiconductor patterns SP2, the hard mask patterns HMP, the gate insulating layers GI, and the barrier layers BA included in the preliminary select plugs pSPL. The first upper insulating layer UIL1 may include an oxide material.

A slit opening SOP is formed through the first upper insulating layer UIL1 and the preliminary stack pSTK. The side surfaces of the sacrificial layers SF are exposed through the slit opening SOP. The sacrificial layers SF are replaced by the conductive layers CD through the slit opening SOP. The cell plugs CPL and the support structures SS support the interlayer insulating layers IL while the sacrificial layers SF are removed to provide an empty space between the interlayer insulating layers IL. The conductive layers CD and the interlayer insulating layers IL constitute the stack STK.

Referring to FIG. 4H, the slit structure SI filling the slit opening SOP is formed. The slit structure SI includes a slit insulating layer. For example, the slit opening SOP may be filled with an insulating material to form the slit insulating layer. The slit insulating layer may include a material having a high etch selectivity with respect to the first upper insulating layer UIL1.

A segment of the first upper insulating layer UIL1 is removed to form the first upper insulation pattern UIP1 and the isolation structure IS. For example, after a first etch process is performed to reduce the height of the first upper insulating layer UIL1, a second etch process is performed to remove the remaining areas of the first upper insulating layer UIL1, except for the first upper insulation pattern UIP1 and the isolation structure IS. Thus, the first upper insulating pattern UIP1 and the isolation structure IS include the same material. The first upper insulating pattern UIP1 and the isolation structure IS have a similar height. The height of the isolation structure IS shorter than the height of the channel pillars CHP. When a section of the first upper insulating layer UIL1 remains un-etched during the second etching process, the residual section RP as shown in FIG. 3C is formed.

The isolation structure IS contacts the preliminary select plugs pSPL. The first upper insulation pattern UIP1 is disposed over or overlaps the steps of the stack STK.

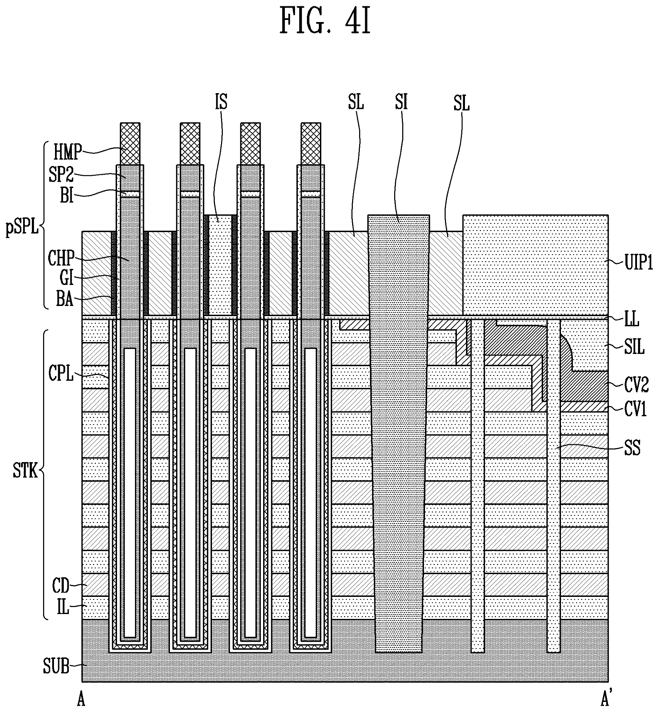

Referring to FIG. 4I, the select lines SL are formed on the stack STK. Consecutive select lines SL are separated by the isolation structure IS and the slit structure SI. The select lines SL contact the preliminary select plugs pSPL. The select lines SL may fill the space between the preliminary select plugs pSPL. For example, a conductive material is formed to cover the stack STK, the preliminary select plugs pSPL, the isolation structure IS, the slit structure SI, and the first upper insulation pattern UIP1. A section of the conductive layer is removed and separated into a plurality of select lines SL. The height of the select lines SL is lower than the height of the isolation structure IS.

A section of the barrier layer BA is removed. Areas of the barrier layer BA not covered by the select line SL or the isolation structure IS are removed.

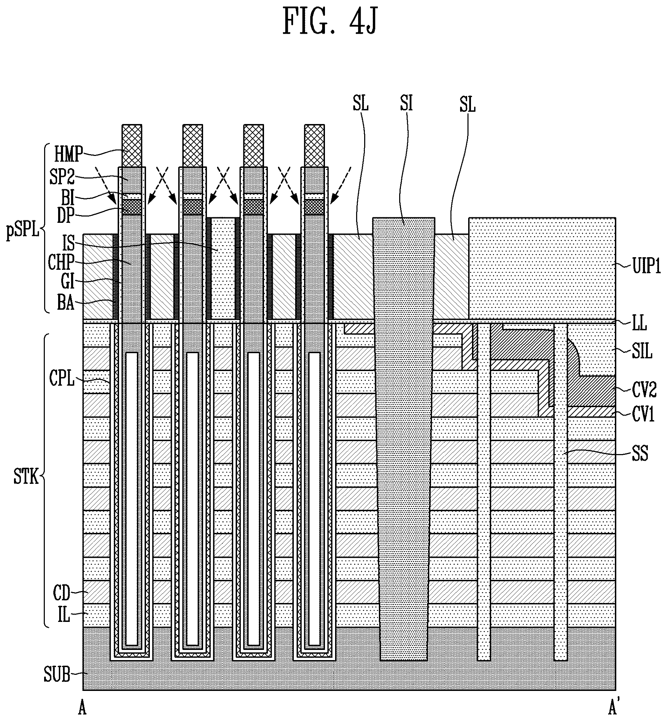

Referring to FIG. 4J, impurities are injected into the channel pillars CHP to form the doped regions DP. The doped regions DP are located adjacent to the lower surface of the barrier insulating layers BI. The doped regions DP are located at adjacent to the top of the channel pillars CHP. A junction is formed by an implantation process that injects impurities into one region of the channel pillar CHP.

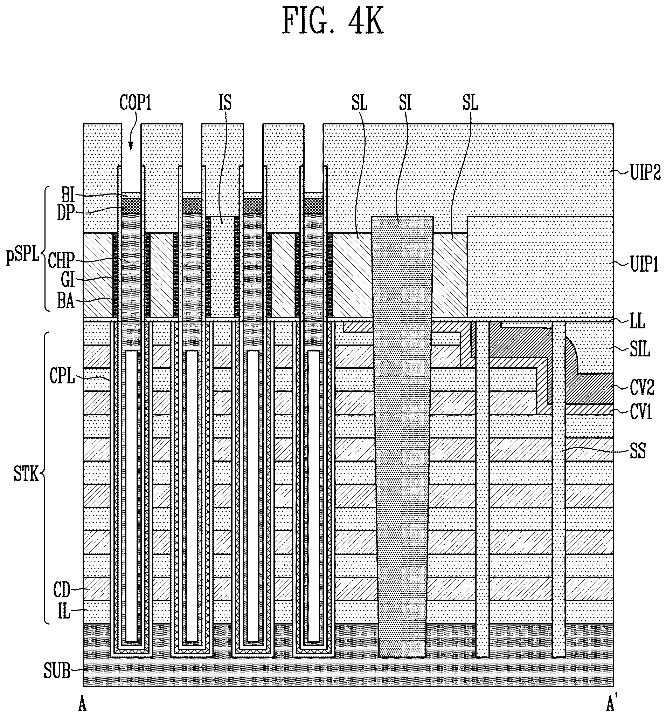

Referring to FIG. 4K, the second upper insulation pattern UIP2 covering the preliminary select plugs pSPL, the select lines SL, the slit structure SI, and the first upper insulation pattern UIP1 is formed. The upper surface of the second upper insulation pattern UIP2 is at the same level as the upper surface of each of the hard mask patterns HMP. The upper surface of each of the hard mask patterns HMP is exposed through the second upper insulating pattern UIP2.

The hard mask patterns HMP are removed. The second semiconductor patterns SP2 are removed. As the hard mask patterns HMP and the second semiconductor patterns SP2 are removed, the upper surfaces of the barrier insulating layers BI are exposed and segments of the inner side surfaces of the gate insulating layers GI are exposed. Spaces from which the hard mask patterns HMP and the second semiconductor patterns SP2 are removed are referred to as first contact openings COP1.

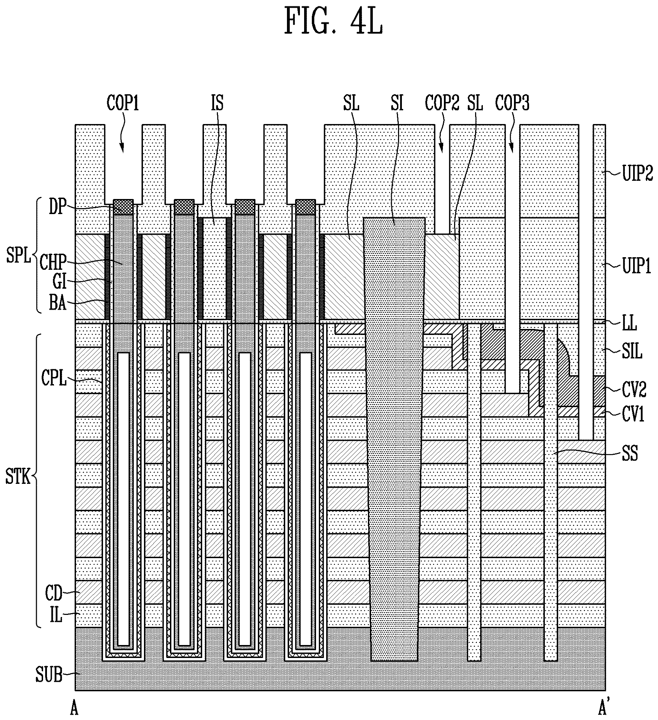

Referring to FIG. 4L, the first contact openings COP1 are expanded. For example, the barrier insulating layers BI, a segment of each of gate insulating layers GI, and a section of the second upper insulation pattern UIP2 exposed through the first contact openings COP1 are etched. The width and depth of the first contact openings COP1 may be increased more than the width and depth shown in FIG. 4K. The doped regions DP are exposed through the expanded first contact openings COP1. The select plug SPL includes the channel pillar CHP including the doped regions DP, the gate insulating layer GI, and the barrier layer BA.

A second contact opening COP2 is formed through the second upper insulation pattern UIP2, through which second contact opening COP2 the select line SL is exposed. Third contact openings COP3 are formed through the second upper insulation pattern UIP2, the first upper insulation pattern UIP1, the liner layer LL, the stepped insulating layer SIL, the second cover layer CV2, the first cover layer CV1, and the interlayer insulating layer IL through which third contact openings COP3 corresponding conductive layers CD are exposed.

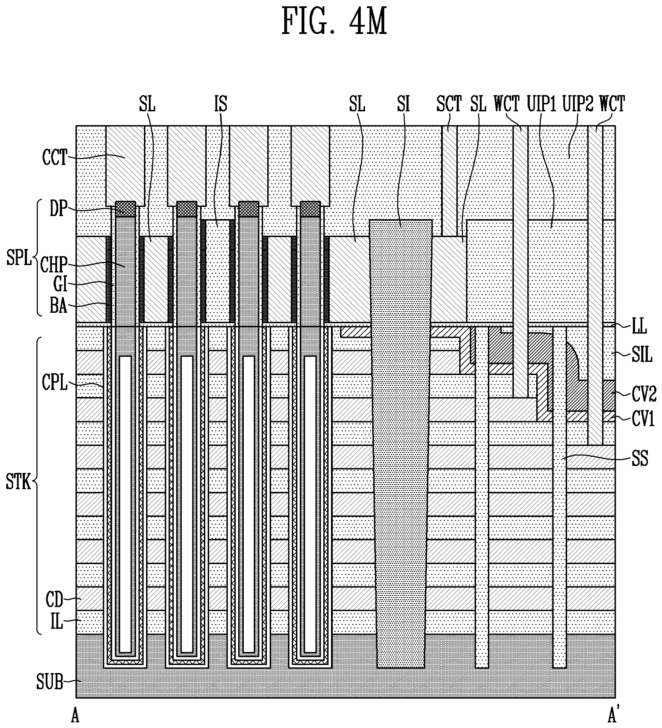

Referring to FIG. 4M, the first contact opening COP1, the second contact opening COP2, and the third contact opening COP3 are filled with a conductive material. The cell contacts CCT are formed in the first contact openings COP1. The select line contact SCT is formed in the second contact opening COP2. The word line contacts WCT are formed in the third contact openings COP3.

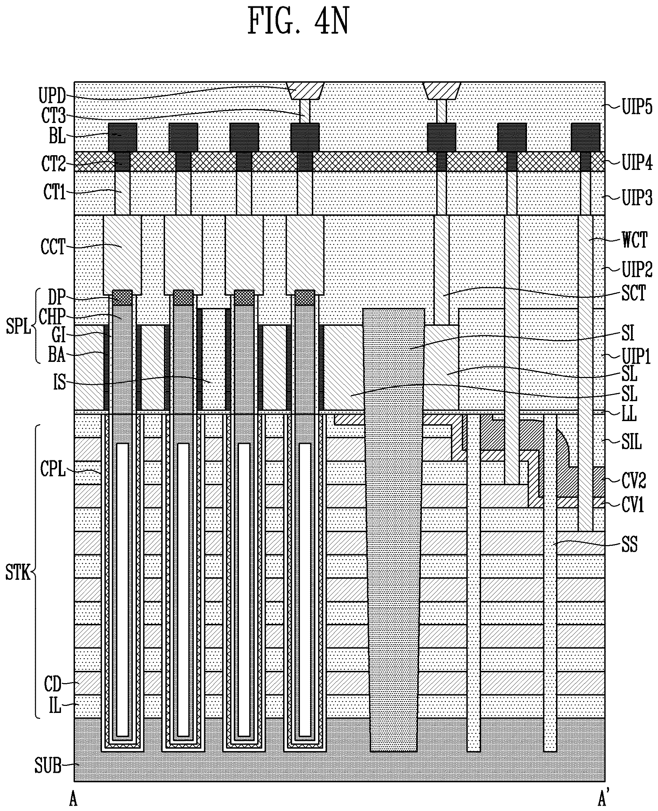

Referring to FIG. 4N, a third upper insulation pattern UIP3 is formed to cover the second upper insulation pattern UIP2, the cell contacts CCT, the select line contacts SCT, and the word line contacts WCT. The third upper insulation pattern UIP3 may include an oxide material. First contacts CT1 are formed through the third upper insulating pattern UIP3. one of the first contacts CT1 contacts a different one of the cell contacts CCT, the select line contacts SCT, and the word line contacts WCT. The first contacts CT1 may include a conductive material.

A fourth upper insulation pattern UIP4 is formed on top of the third upper insulation pattern UIP3 and the first contacts CT1. The fourth upper insulating pattern UIP4 may include a nitride material. Second contacts CT2 are formed through the fourth upper insulating pattern UIP4. One of the second contacts CT2 contacts a different one of the first contacts CT1. The second contacts CT2 may include a conductive material.

The bit lines BL, a third contact CT3, upper bonding pads UPD, and a fifth upper insulation pattern UIP5 are formed over the fourth upper insulation pattern UIP4. The bit lines BL, the third contact CT3, and the upper bonding pads UPD may each include a conductive material. The upper bonding pads UPD are exposed through the upper surface of the fifth upper insulating pattern UIP5.

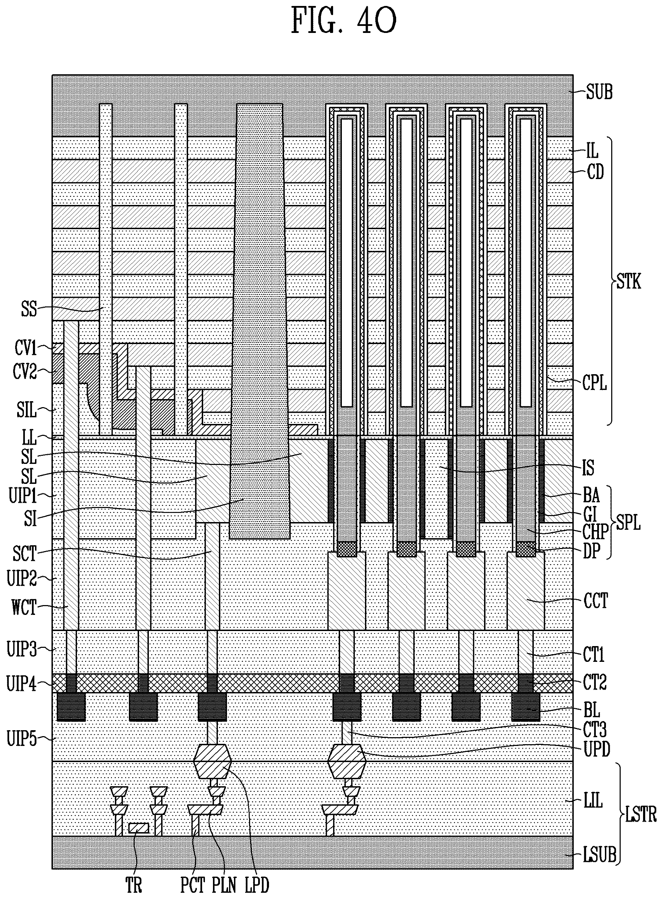

Referring to FIG. 4O, a lower structure LSTR including a lower substrate LSUB, a lower insulating layer LIL, a transistor TR, a peripheral circuit contact PCT, peripheral wiring PLN, and lower bonding pads LPD are formed. The lower structure LSTR may include the substrate SST and the peripheral circuit structure PC of FIG. 2.

The structure of FIG. 4N may be flipped upside down and bonded to the lower structure LSTR. The upper bonding pads UPD contact corresponding lower bonding pads LPD.

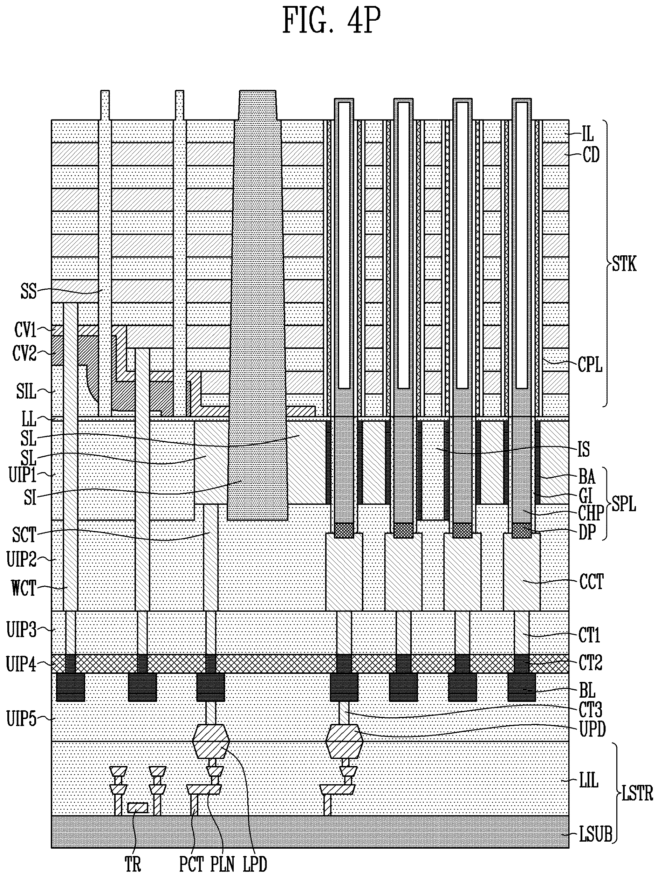

Referring to FIG. 4P, the substrate SUB is removed. A section of the blocking layer BX, a section of the charge trap layer CT, and a section of the tunneling layer TX included in the cell plugs CPL are removed. Thus, the channel layers CH are exposed. While the section of the blocking layer BX, the section of the charge trap layer CT, and the section of the tunneling layer TX are etched, a section of each of the support structures SS and the slit structure SI may be etched.

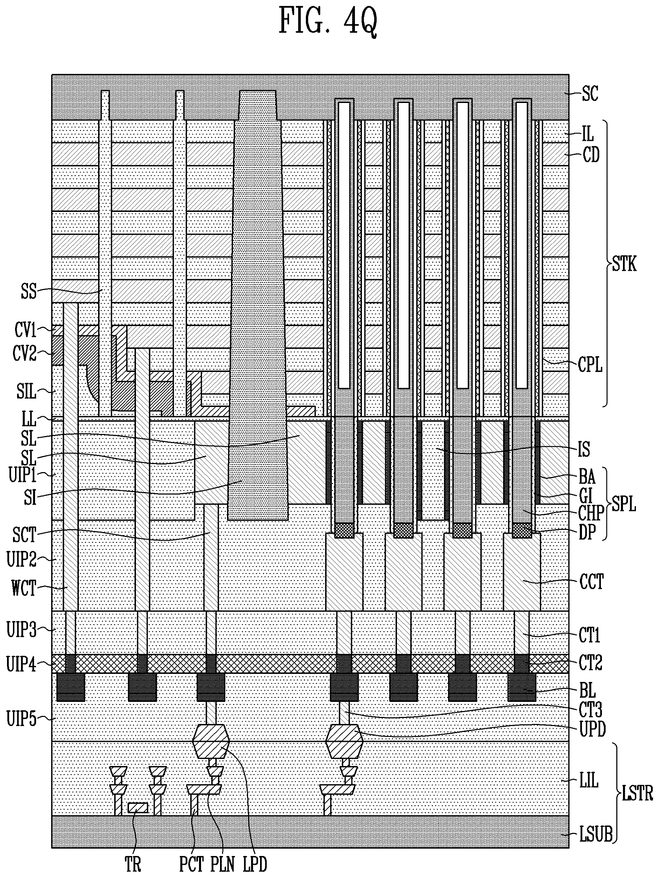

Referring to FIG. 4Q, the source line SC contacting the channel layer CH of the cell plugs CPL is formed. The source line SC corresponds to the source line SC of FIG. 1. The source line SC may include silicon.

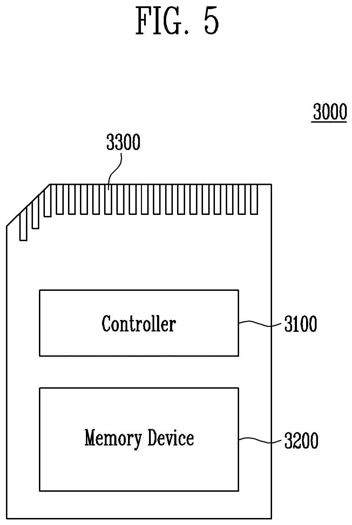

FIG. 5 is a block diagram illustrating a memory card system 3000 according to an embodiment of the present disclosure.

Referring to FIG. 5, the memory card system 3000 includes a controller 3100, a memory device 3200, and a connector 3300.

The controller 3100 is coupled to the memory device 3200. The controller 3100 accesses the memory device 3200. For example, the controller 3100 controls a program operation, a read operation, an erase operation, and a background operation of the memory device 3200. The controller 3100 is configured as an interface between the memory device 3200 and a host. The controller 3100 is configured to drive firmware that controls the memory device 3200. For example, the controller 3100 may include components such as a Random-Access Memory (RAM), a host interface, a memory interface, and an ECC circuit.

The controller 3100 communicates with an external device through the connector 3300. The controller 3100 communicates with an external device, such as a host, based on a communication protocol. For example, the controller 3100 may communicate with the external device using at least one of various communication protocols such as universal serial bus (USB), multimedia card (MMC), embedded MMC (eMMC), peripheral component interconnection (PCI), PCI-express (PCI-E), advanced technology attachment (ATA), serial-ATA (SATA), parallel-ATA (PATA), small computer system interface (SCSI), enhanced small disk interface (ESDI), integrated drive electronics (IDE), Firewire, universal flash storage (UFS), WiFi, Bluetooth, and nonvolatile memory express (NVMe) protocols. In an embodiment, the connector 3300 is configured according to at least one of these various communication protocols.

The memory device 3200 includes a plurality of memory cells and is configured similar to the memory device 100 shown in FIG. 1, FIG. 2, FIG. 3A through FIG. 3D, and FIG. 4A through FIG. 4Q.

The controller 3100 and the memory device 3200 may be integrated into a single semiconductor device to form a memory card. For example, the controller 3100 and the memory device 3200 may be integrated into a single semiconductor device to form a memory card, such as a personal computer memory card international association (PCMCIA) card, a compact flash (CF) card, a smart media card (SM, or SMC), a memory stick, a multimedia card (MMC, RS-MMC, MMCmicro, or eMMC), an SD card (SD, miniSD, microSD, or SDHC), a universal flash storage (UFS), and the like.

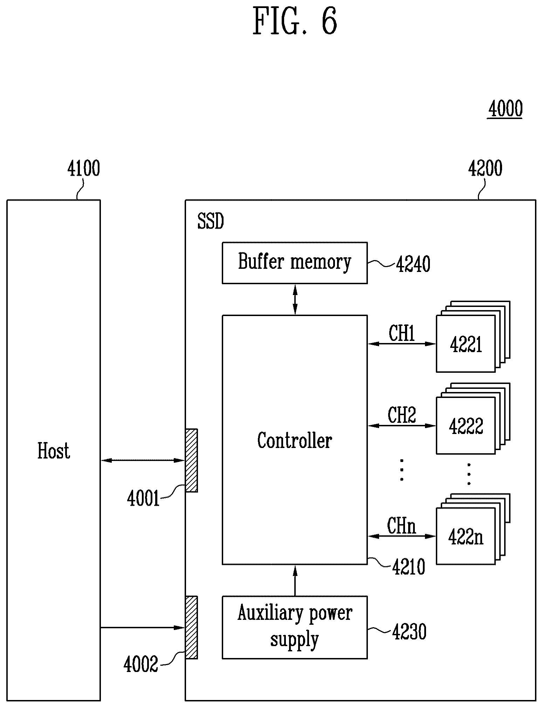

FIG. 6 is a block diagram illustrating a solid-state drive (SSD) system 4000 including a memory device according to an embodiment of the present disclosure.

Referring to FIG. 6, the SSD system 4000 includes a host 4100 and an SSD 4200. The SSD 4200 exchanges signals with the host 4100 via a signal connector 4001 and receives power via a power connector 4002. The SSD 4200 includes a controller 4210, a plurality of memory devices 4221 to 422n, an auxiliary power supply 4230, and a buffer memory 4240.

The controller 4210 controls the plurality of memory devices 4221 to 422n in response to the signals received from the host 4100. In an embodiment, the signals are based on the interfaces of the host 4100 and the SSD 4200. For example, the signals may be configured according to at least one of various interfaces such as universal serial bus (USB), multimedia card (MMC), embedded MMC (eMMC), peripheral component interconnection (PCI), PCI-express (PCI-E), advanced technology attachment (ATA), serial-ATA

(SATA), parallel-ATA (PATA), small computer system interface (SCSI), enhanced small disk interface (ESDI), integrated drive electronics (IDE), Firewire, universal flash storage (UFS), WiFi, Bluetooth, and nonvolatile memory express (NVMe) interfaces.

The plurality of memory devices 4221 to 422n includes a plurality of memory cells configured to store data. Each of the plurality of memory devices 4221 to 422n is configured similar to the memory device 100 shown in FIG. 1, FIG. 2, FIG. 3A through FIG. 3D, and FIG. 4A through FIG. 4Q.. The plurality of memory devices 4221 to 422n communicate with the controller 4210 via channels CH1 to CHn.

The auxiliary power supply 4230 is coupled to the host 4100 through the power connector 4002. The auxiliary power supply 4230 is supplied and charged with the power from the host 4100. The auxiliary power supply 4230 supplies the power for the SSD 4200 when the power supplied from the host 4100is not reliable or smooth. The auxiliary power supply 4230 may be located inside or outside the SSD 4200. For example, the auxiliary power supply 4230 is disposed on a main board and supplies auxiliary power to the SSD 4200.

The buffer memory 4240 is a buffer memory for the SSD 4200. For example, the buffer memory 4240 stores data received from the host 4100 or data received from the plurality of memory devices 4221 to 422n, or stores metadata, such as mapping tables, of the memory devices 4221 to 422n. The buffer memory 4240 may include volatile memories such as DRAM, SDRAM, DDR SDRAM, and LPDDR SDRAM, and/or nonvolatile memories such as FRAM, ReRAM, STT-MRAM, and PRAM.

According to the present disclosure, by improving the structures of select lines and an isolation structure, the volume of a memory device may be reduced relative to conventional memory devices.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to these descriptions. All changes within the meaning and range of equivalency of the claims are included within their scope.

## Claims

1. A memory device comprising:
a plurality of cell plugs extending through a stack;
each of a plurality of select plugs coupled to a different one of the plurality of cell plugs and disposed over the stack;
a plurality of select lines disposed over the stack, a first select line surrounding a first plurality of the plurality of select plugs and a second select line surrounding a second plurality of the plurality of select plugs; and
an isolation structure separating the first select line from the second select line and contacting a subset of the plurality of select plugs.

2. The memory device of claim 1, wherein each of the plurality of select plugs comprises:
a channel pillar;
a gate insulating layer contacting a side surface of the channel pillar; and
a barrier layer contacting a side surface of the gate insulating layer.

3. The memory device of claim 2, wherein the gate insulating layer surrounds at least a section of the channel pillar.

4. The memory device of claim 2, further comprising a liner layer extending along a surface of the stack,
wherein the liner layer extends from the gate insulating layer.

5. The memory device of claim 2, wherein the barrier layer comprises at least one of:
a first section arranged between the gate insulating layer and one of the plurality of select lines; and
a second section arranged between the gate insulating layer and the isolation structure.

6. The memory device of claim 5, wherein the first section of the barrier layer does not extend beyond the plurality of select lines.

7. The memory device of claim 5, wherein the second section of the barrier layer does not extend beyond the isolation structure.

8. The memory device of claim 5, wherein a height of the first section of the barrier layer is shorter than a height of the second section of the barrier layer.

9. The memory device of claim 2, wherein the channel pillar comprises a doped region; and
wherein the gate insulating layer surrounds at least a section of a side surface of the doped region.

10. The memory device of claim 9, further comprising a cell contact in contact with the doped region.

11. The memory device of claim 1, wherein a height of the isolation structure is shorter than a height of the plurality of select plugs.

12. The memory device of claim 1, wherein a height of the isolation structure is taller than a height of the plurality of select lines in a first direction.

13. The memory device of claim 1, wherein the isolation structure fills space between consecutive select plugs among the plurality of select plugs, and wherein the isolation structure is interposed between the consecutive select plugs.

14. The memory device of claim 1, wherein the select plugs extend toward the plurality of cell plugs and extend between the isolation structure and the select lines.

15. The memory device of claim 1, wherein a width at a first end of the isolation structure is wider than or equal to a width at a second end of the isolation structure.
